# EUROPÄISCHE PATENTSCHRIFT

(11) **EP 2 774 138 B1**
(45) Veröffentlichungstag und Bekanntmachung des Hinweises auf die Patenterteilung: **27.07.2016**
(21) Anmeldenummer: 12784545.1
(22) Anmeldetag: 30.10.2012
(51) Int. Cl.: G09F 9/33

(54) **BILDWIEDERGABEANORDNUNG MIT RAUMSPAREND BEFESTIGTER FRONTSCHEIBE**
IMAGE REPRODUCTION ASSEMBLY HAVING A FRONT PANE FASTENED IN A SPACE-SAVING MANNER
SYSTÈME DE REPRODUCTION D'IMAGES AVEC VITRE FRONTALE FIXÉE DE MANIÈRE À ÉCONOMISER DE L'ESPACE

(30) Priorität: 02.11.2011 DE 102011085613
(43) Veröffentlichungstag der Anmeldung: 10.09.2014
(73) Patentinhaber: Tridelity AG, 78112 St. Georgen (DE)
(72) Erfinder: SIGWART, Johannes, 78183 Hüfingen (DE)
(74) Vertreter: Patentanwälte Bressel und Partner mbB
(86) Internationale Anmeldenummer: PCT/EP2012/071476
(87) Internationale Veröffentlichungsnummer: WO 2013/064496

(56) Entgegenhaltungen:
- WO-A1-2006/098727
- FR-A1- 2 797 341
- US-A1- 2005 178 034

## Beschreibung

Die vorliegende Erfindung betrifft eine Bildwiedergabeanordnung mit einer Frontscheibe und eine Anordnung aus mehreren solcher Bildwiedergabeanordnungen.

Seit einigen Jahren werden verstärkt großformatige Anzeigesysteme zur Visualisierung von Bildinhalten eingesetzt. Diese Großbildschirme ersetzen dabei immer mehr gedruckte Plakate oder Werbeflächen. Abhängig von der Größe des Systems kommt die seit Jahren verbreitete LCD-Technologie oder - bei sehr großen Flächen- auch die LED-Technologie zur Anwendung.

LED- und LCD- Bildwiedergabeanordnungen weisen eine Bilddarstellungsmatrix auf, durch deren Matrixelemente Bilder dargestellt werden. Die Matrixelemente sind meistens in Zeilen und Spalten angeordnet. Die Matrixelemente sind beispielsweise bei LCD Bildwiedergabeanordnungen verschiedenfarbige Subpixel, die wiederum zu Pixel zusammengesetzt sind. Neben Matrixelementen kann die Bilddarstellungsmatrix auch eine Elektronik enthalten, die die Matrixelemente ansteuert. Im Vergleich zur Bilddarstellungsmatrix bezeichnet der Begriff "Display" eine Bildwiedergabeanordnung, die neben einer Bilddarstellungsmatrix weitere Komponenten aufweist, wie beispielsweise einen Controller der die Signalverarbeitung übernimmt, einen Inverter, der die Hintergrundhelligkeit steuert, ein Netzteil das alle anderen Komponenten mit Spannung versorgt, und ein Gehäuse, in das die Komponenten eingebaut sind.

LCDs sind technologiebedingt nur in bestimmten Maximalgrößen herstellbar. Auf Basis der LED-Technologie hingegen können zwar große Wände aufgebaut werden, diese haben aber technologiebedingt u.a. eine sehr viel schlechtere Auflösung bezogen auf eine Größeneinheit (beispielsweise bezogen auf eine Flächeneinheit, wie m²) als LCD-Displays.

Zur Kombination der Vorteile beider Technologien werden in jüngster Zeit vermehrt mehrere großformatige LCD-Displays neben und/oder übereinander angeordnet, zusammengeschaltet und mit einer speziellen Software angesteuert. Hierbei zeigt dann jedes Einzel-Display nur den ihm zugeordneten Teil des Gesamtbildinhaltes. Die Anordnung mehrerer Displays zeigt das Gesamtbild. Problematisch hierbei ist, dass Bilddarstellungsmatrices in ein Gehäuse eingefasst sind, welches in Richtung des Betrachters in Form eines üblicherweise umlaufenden Randes oder Rahmens sichtbar ist aufweisen. Diese Rahmen tragen nicht zur Bilderzeugung bei, weisen insbesondere keine Matrixelemente auf, und durchqueren die Gesamtbildfläche einer Anordnung aus mehreren Bilddarstellungsmatrices als störende Streifen.

Es gibt speziell für Videowall-Einsatzzwecke gefertigte LCD- Bilddarstellungsmatrices, die einen sehr dünnen Rahmen aufweisen. Sie werden als Steglos-, Seamless- oder auch Narrow Bezel Displays bezeichnet und ermöglichen eine weniger durch Unterbrechungen optisch beeinträchtigte Videowand.

Es gibt verschiedenen Anwendungen für Displays, insbesondere LCD-basierte, welche die Anbringung einer Frontscheibe vor der Bilddarstellungsmatrix erfordern:
a) Schutzscheibe
   In Anwendungen z.B. an öffentlichen Plätzen sind zum Teil Displays erforderlich, die gegen Vandalismus gesichert sind und zu diesem Zwecke mit einer schlagfesten und bruchsichereren Schutzscheibe versehen sind. Beispielsweise schützen Verbundgläser eine dahinter liegende Bilddarstellungsmatrix vor Beschädigungen.
b) Touchscreen
   In vielen Anwendungen wird die tastaturfreie Bedienung z.B. per Touchscreen benötigt. Hierzu werden LCD-Displays beispielsweise mit berührungsempfindlichen Gläsern (sog. Touch-Scheiben) ausgestattet, diese Touchscheiben dienen als Eingabegerät für den angeschlossenen oder in das Display integrierten PC.
c) 3D-Displays
   Neueste Technologien bieten die Möglichkeit, speziell aufbereitete Bildinhalte räumlich auf LCD-Displays darzustellen. Dies kann einerseits unter der Zuhilfenahme von Brillen (stereoskopisch), oder andererseits ohne die Notwendigkeit von Brillen (autostereoskopisch) umgesetzt werden. Beide Möglichkeiten benötigen jedoch die Anbringung von speziellen Filterscheiben vor der Bilddarstellungsmatrix.

Alle drei Anwendungsbeispiele können einzeln oder teilweise auch miteinander kombiniert genutzt werden, und haben die Gemeinsamkeit dass vor der Bilddarstellungsmatrix eine zusätzliche Scheibe angebracht werden muss. Während die Scheiben bei a) und b) relativ einfach und ungenau vor der Bilddarstellungsmatrix angebracht werden können, muss die Scheibe für Anwendungen nach c) sehr exakt positioniert werden. Dies gilt einerseits für die Ausrichtung in X- und Y-Richtung zur Sichtachse, als auch für die (mitunter beträchtlichen) Distanz zur Bilddarstellungsmatrix (Z-Richtung), sowie den Winkel um diese Z-Achse. Abweichungen von Millimeterbruchteilen können sich hier sehr negativ auf das wahrnehmbare Bild auswirken.

Da die Frontscheiben insbesondere für großformatige Displays häufig eine Mindestdicke von ca. 3-5 mm aufweisen, und zudem Frontscheiben im Fall von Glas ein hohes Eigengewicht haben, sind stabile mechanische Befestigungs- und Justierungselemente erforderlich.

Bekannte Befestigungs- und Justierungselemente für Frontscheiben sind üblicherweise seitlich am Gehäuse einer Bilddarstellungsmatrix angebracht. Das Gehäuse erscheint aus Sicht des Betrachters als Rahmen oder Rand um die Bilddarstellungsmatrix. Durch seitliche Anbringung von Befestigungs- und Justierungsmitteln wird der Rahmen um die Bilddarstellungsmatrix verbreitert, was bei einer Anordnung mehrerer Displays aneinander zu störenden Streifen zwischen den Bilddarstellungsmatrices führt.

Dokument US 200510 178 034 A ist als nächsliegender Stand der Technik angesehen.

Eine Aufgabe der vorliegenden Erfindung war die Bereitstellung einer Bildwiedergabeanordnung mit einer Frontscheibe, bei der über die Bilddarstellungsmatrix herausreichende Randbereiche möglichst minimiert werden sollten. Insbesondere bei einer Anordnung mehrerer Bildwiedergabeanordnung neben und/oder übereinander sollten möglichst schmale Übergänge zwischen den Bilddarstellungsmatrices der einzelnen Bildwiedergabeanordnungen sichtbar sein.

Insbesondere sollten Befestigungs- und Justierungselemente für eine Frontscheibe einer Bildwiedergabeanordnung so gestaltet sein, dass der aus Benutzerrichtung sichtbare Bereich der Befestigungs- und Justierungselemente möglichst schmal erscheint.

Diese Aufgabe wird durch eine Bildwiedergabeanordnung nach Anspruch 1 gelöst. Vorteilhafte Ausgestaltungen sind in den Unteransprüchen angegeben.

Vorgeschlagen wird eine Bildwiedergabeanordnung, aufweisend
- eine zweidimensionale, Bilddarstellungsmatrix, die von Rändern umgrenzt ist und durch deren Matrixelemente Bilder darstellbar sind,
- angrenzend zu den Rändern der Bilddarstellungsmatrix angebrachte Befestigungselemente,
- eine Frontscheibe, die an den Befestigungselementen befestigt ist und in einer Ebene vor der Bilddarstellungsmatrix fixiert ist,
   wobei jedes Befestigungselement
- mindestens teilweise über die Ebene der Bilddarstellungsmatrix hervorspringt,
- mindestens teilweise über den Rand der Bilddarstellungsmatrix quer zur Blickrichtung eines Betrachters hervorspringt, und
   wobei die Befestigungselemente entlang der Ränder so angeordnet sind, dass
- zwischen Befestigungselementen und/oder angrenzend zu einem oder mehrerenBefestigungselementen Aussparungen vorhanden sind,
und bei einer Anordnung mehrerer solcher Bildwiedergabeanordnungen neben- und/oder übereinander
- die Befestigungselemente einer ersten Bildwiedergabeanordnung in den Aussparungen einer oder mehrerer zur ersten Bildwiedergabeanordnung benachbarter Bildwiedergabeanordnungen positionierbar sind und
- die Befestigungselemente einer oder mehrerer zur ersten Bildwiedergabeanordnung benachbarter Bildwiedergabeanordnungen in den Aussparungen der ersten Bildwiedergabeanordnung positionierbar sind.

Eine weitere Aufgabe der Erfindung, die durch spezielle Ausführungsformen gelöst wird, bestand darin, Frontscheiben möglichst exakt in einem fest definierten Abstand vor einem einer Bilddarstellungsmatrix anbringen und justieren zu können.

Die Bilddarstellungsmatrix weist Matrixelemente, auch bezeichnet als Segmente, auf, die in einem gleichmäßigen Raster angeordnet sind. Besonders bevorzugt ist die Anordnung in Zeilen und Spalten.

Die Ränder, von denen die Bilddarstellungsmatrix umgrenzt ist, können beispielsweise Teil eines Gehäuses sein, in dem die Bilddarstellungsmatrix untergebracht ist bzw. welches die Bilddarstellungsmatrix umgrenzt. Vorzugsweise bilden die Ränder einen die Bilddarstellungsmatrix umlaufenden Rahmen. Die Breite eines Randes beträgt beispielsweise ca. 2 bis 10 mm, bevorzugt 2 bis 4 mm.

Die Befestigungselemente sind angrenzend zu den Rändern angebracht. Insbesondere können sie an einem Gehäuse befestigt sein, das die Bilddarstellungsmatrix einfasst und das Ränder aufweist, welche die Bilddarstellungsmatrix umgrenzen.

Die Befestigungselemente können die Ränder der Bilddarstellungsmatrix teilweise verdecken. Die aktive Bildfläche bzw. Matrixelemente der Bilddarstellungsmatrix werden vorzugsweise von den Befestigungselementen nicht verdeckt, auch nicht teilweise.

Jedes Befestigungselement springt zumindest teilweise über die Ebene der Bilddarstellungsmatrix hervor. Anders ausgedrückt weist jedes Befestigungselement einen vorspringenden Teil auf, der über die Ebene der Bilddarstellungsmatrix in Richtung eines Betrachters hervorspringt.

Der Begriff "Befestigungselement" bedeutet insbesondere, dass an diesem Element die Frontscheibe befestigt ist. Das Befestigungselement weist mindestens eine Befestigungsstelle zur Befestigung einer Frontscheibe auf.

Der Befestigungsmechanismus ist in keiner Weise beschränkt. Das Befestigungselement kann einteilig oder mehrteilig aufgebaut sein. Das Befestigungselement kann zur Befestigung einer Frontscheibe beispielsweise Schrauben, insbesondere Klemmschrauben, Klemmelemente, Klemmleisten, Rastpositionen, Steckelemente aufweisen, welche abnehmbar sein können.

Das Befestigungselement kann an einem Träger, beispielsweise an einer Profillleitste angebracht sein, beispielsweise durch Schrauben oder Kleben, oder es kann ein integraler Bestandteil eines Trägers sein, wobei das Befestigungselement als Teil der Trägers ausgeformt ist, also eine Ausformung an einem Träger darstellt. Der Träger ist wiederum am Rand der Bilddarstellungsmatrix angeordnet, insbesondere am Rand der Bilddarstellungsmatrix befestigt. Auf eine spezielle Ausführungsform einer Profilleiste, wo dieses Prinzip verwirklicht ist, wird später noch eingegangen.

Zwischen den vorspringenden Teilen der Befestigungselemente, ist die Frontscheibe angeordnet. Die Befestigungselemente bzw. deren vorspringende Teile definieren einen Bereich, in dem die Frontscheibe vor der Bilddarstellungsmatrix in X- und Y-Richtung (quer zur Blickrichtung des Betrachters) bewegt und positioniert werden kann. Die Befestigungselemente können derart ausgestaltet und angeordnet sein, dass die Frontscheibe mit Teilen ihres Randes an den vorspringenden Teilen der Befestigungselemente spaltfrei anliegt. Andererseits können bei eingelegter Frontscheibe zwischen den vorspringenden Teilen der Befestigungselemente und der Frontscheibe Spalte vorhanden sein. Die Frontscheibe ist in dieser Ausführungsform zwischen den vorspringenden Teilen beweglich. In dieser Ausführungsform definieren die vorspringenden Teile einen Bereich, in dem die Frontscheibe parallel zur Bilddarstellungsmatrix verschiebbar ist. Die vorspringenden Teile bilden in dieser Ausführungsform Außenabgrenzungen des Bereichs. Innerhalb des Bereichs kann die Frontscheibe quer zur Blickrichtung des Betrachters soweit in jede Richtung verschoben werden, bis sie an einem oder mehreren vorspringenden Teilen anschlägt. Die Frontscheibe kann in dieser Ausführungsform in x-Richtung und y-Richtung (quer zur Sichtachse des Betrachters) exakt vor der Bilddarstellungsmatrix positioniert werden, was insbesondere für 3D-Anwendungen und die dort eingesetzten Frontscheiben vorteilhaft ist.

In einer speziellen Ausführungsform sind die vorspringenden Teile der Befestigungselemente so ausgestaltet und angeordnet, dass eine zwischen die vorspringenden Teile eingelegte Frontscheibe um eine parallel zur Blickrichtung des Betrachters verlaufende Achse (z-Achse) verdrehbar ist. Eine Verdrehbarkeit ist insbesondere für 3D-Anwendungen und die dort eingesetzten Frontscheiben von Vorteil. Eine Verschiebbarkeit und/oder Verdrehbarkeit der Frontscheibe zwischen den vorspringenden Teilen der Befestigungselemente kann auch erreicht werden, indem die Scheibe entsprechend dimensioniert wird.

Vorzugsweise weist jedes Befestigungselement eine Auflagefläche für die Frontscheibe auf. Der vorspringende Teil eines Befestigungselements kann neben der Auflagefläche für die Frontscheibe angeordnet sein.

Die Befestigungselemente sind entlang der Ränder so angeordnet, dass zwischen Befestigungselementen und/oder angrenzend zu einem oder mehreren Befestigungselementen Aussparungen vorhanden sind. Eine Aussparung, die an ein Befestigungselement angrenzt, kann sich beispielsweise von einem Ende des Befestigungselements bis zu einem Ende des Randes, beispielsweise einer Ecke im Fall einer rechteckigen Bilddarstellungsmatrix, erstrecken. Aussparungen zwischen Befestigungselementen werden jeweils von zwei Befestigungselementen begrenzt. Eine Aussparung zwischen zwei Befestigungselementen kann auch als Lücke oder Zwischenraum bezeichnet werden. Der Begriff "Aussparung" bedeutet im Sinne der vorliegenden Erfindung nicht unbedingt, dass am Ort der Aussparung Material des Randes entfernt wurde, sondern er kann auch bedeuten, dass in diesem Bereich des Randes kein Befestigungselement angeordnet ist. Jedes Befestigungselement ragt zumindest teilweise über den Rand der Bilddarstellungsmatrix quer zur Blickrichtung des Betrachters hinaus. Im Bereich der Aussparungen ist entweder kein über den Rand der Bilddarstellungsmatrix quer zur Blickrichtung eines Betrachters hinausragendes Element vorhanden oder es ist allenfalls eine Element oder Bauteil, gleich welcher Funktion, vorhanden, dass weniger über den Rand der Bilddarstellungsmatrix hinausragt, als ein an die Aussparung angrenzendes Befestigungselement.

Bei einer Anordnung mehrerer der beschriebenen Bildwiedergabeanordnungen neben- und/oder übereinander greifen die Befestigungselemente einer ersten Bildwiedergabeanordnung in die Aussparungen ein, die an den Rändern benachbarter Bildwiedergabeanordnungen vorgesehen sind. Umgekehrt greifen die Befestigungselemente benachbarter Bildwiedergabeanordnungen in die Aussparungen ein, die an den Rändern der ersten Bildwiedergabeanordnung vorgesehen sind. Dieses Prinzip ist beliebig fortsetzbar. D. h., bei zueinander benachbarten Bildwiedergabeanordnungen greifen die Befestigungselemente der einen Bildwiedergabeanordnung in die Aussparungen der anderen Bildwiedergabeanordnung ein und umgekehrt. Vorzugsweise greift je ein Befestigungselement in eine Aussparung ein.

Bei einer Anordnung mehrerer der beschriebenen Bildwiedergabeanordnungen neben- und/oder übereinander sind entlang benachbarter, parallel zueinander angeordneter Ränder benachbarter Bildwiedergabeanordnungen die Befestigungselemente der Bildwiedergabeanordnungen zueinander versetzt positioniert. Bei Betrachtung entlang der parallel zueinander angeordneten Ränder benachbarter Bildwiedergabeanordnungen erhält man eine Abfolge von Befestigungselementen, die abwechselnd den beiden benachbarten Bildwiedergabeanordnungen zugeordnet sind. Durch die Anordnung von Befestigungselementen in Aussparungen erhält man schmale Übergänge zwischen den Bilddarstellungsmatrizen verschiedener Bildwiedergabeanordnungen, wenn mehrere Bildwiedergabeanordnungen zu einer übergeordneten Anordnung zusammengesetzt sind.

In einer speziellen Ausführungsform wird eine Bildwiedergabeanordnung angegeben, bei der an gegenüberliegenden Rändern angeordnete Befestigungselemente zueinander punktsymmetrisch um einen Punkt angeordnet sind, der auf der Schnittstelle der beiden Diagonalen der rechteckigen Bilddarstellungsmatrix liegt. Diese Ausführungsform findet insbesondere Anwendung bei einer rechteckigen Bilddarstellungsmatrix.

Durch diese punktsymmetrische Anordnung sind mehrere Bildwiedergabeanordnungen besonders einfach zu einer Anordnung auf mehreren Bildwiedergabeanordnungen zusammensetzbar.

Die Befestigungselemente weisen Klemmelemente auf, die einen Anpressdruck auf die Frontscheibe in Blickrichtung des Betrachters ausüben. Das Klemmelement kann als separates Teil an dem Befestigungselement anbringbar sein. Insbesondere ist ein solches Klemmelement eine Klemmleiste, die am vorspringenden Teil des Befestigungselements fixierbar ist, beispielsweise durch eine oder mehrere Schrauben. In einer weiteren Ausführungsform einer Bildwiedergabeanordnung sind die Befestigungselemente L-förmig ausgestaltet, wobei ein Schenkel des L-förmigen Befestigungselements an der Seite des Gehäuses der Bilddarstellungsmatrix angebracht ist, wobei er direkt oder indirekt an dem Gehäuse anliegen kann, und ein zweiter Schenkel direkt oder indirekt an der Frontscheibe anliegt und einen Anpressdruck auf die Frontscheibe in Richtung der Bilddarstellungsmatrix ausübt. Mit "indirekt anliegen" ist gemeint, dass zwischen dem Schenkel und dem Gehäuse bzw. zwischen dem Schenkel und der Scheibe ein Zwischenelement angeordnet sein kann. In einer speziellen Variante ist zwischen dem ersten Schenkel und dem Gehäuse eine Profilleiste angeordnet, was weiter unten beschrieben ist. Zwischen einem zweiten Schenkel und der Frontscheibe können ein oder mehrere elastische, weiche und/oder komprimierbare Zwischenlagen, z.B. eine Gummischicht oder Polsterlage, oder ein Befestigungsmaterial, z.B. eine Klebeschicht, vorgesehen sein.

Das Befestigungselement weist vorzugsweise eine Auflagefläche für die Frontscheibe auf. Die Frontscheibe liegt mit einer Seite, der vom Betrachter abgewandten Seite, auf der Auflagefläche auf. Ein Klemmelement, wie zuvor genannt, presst vorzugsweise die Frontscheibe gegen die Auflagefläche.

In einer weiteren Ausführungsform wird eine Bildwiedergabeanordnung angegeben, die einen oder mehrere Abstandhalter aufweist, durch welche die Frontscheibe von der Bilddarstellungsmatrix beabstandet positionierbar ist. Durch den/die Abstandhalter kann eine entfernte Positionierung der Frontscheibe vor der Bilddarstellungsmatrix erreicht werden. Der Abstandhalter kann sich vom Rand der Bilddarstellungsmatrix bis zu einer Auflagefläche für die Frontscheibe erstrecken. Bei dieser Ausführungsform kann das das Befestigungselement einen Abstandhalter aufweisen oder benachbart zu einem Abstandhalter angeordnet sein.

Die Frontscheibe kann beispielsweise aus Glas oder Kunststoff, beispielsweise Plexiglas, bestehen. Die Frontscheibe kann eine Schutzscheibe sein, eine Scheibe eines Touchscreens oder eine Scheibe für ein 3D-Display, insbesondere eine Scheibe für ein autostereoskopisches 3D-Display mit einer optisch aktiven Schicht.

Bei einer Art autostereoskopischer Displays werden zur Frontscheiben eingesetzt, die als optisch aktive Schicht eine Anordnung bzw. ein Raster aus Linsen oder linsenförmigen Elementen aufweisen. Solche Frontscheiben sind beschrieben in DE 697 18 534 T2 und werden auch als Linsenrasterscheiben oder Linsenplatten bezeichnet. Eine Linsenplatte der DE 697 18 534 T2 erstreckt sich im Wesentlichen parallel zu der Ebene einer dort so bezeichneten Wiedergabeplatte. Sie weist eine Anordnung länglicher, paralleler Linsenelemente auf, so dass einzelne Bilder, die mittels der Wiedergabeplatte dargestellt werden, für das linke und rechte Auge des Zuschauers wahrnehmbar sind. Entsprechen das Bild für das linke Auge und das Bild für das rechte Auge den natürlichen Blickwinkeln bei Betrachtung eines Objektes oder einer Szene, nimmt der Zuschauer die auf der Wiedergabeplatte erzeugte Darstellung als dreidimensionale Darstellung wahr.

Eine andere Variante von autostereoskopischen Displays arbeitet nach dem so genannten Parallax-Barriere-Prinzip. Bei solchen 3D Displays weisen die Frontscheiben eine Schicht mit lichtdurchlässigen und lichtundurchlässigen Bereichen auf. Die Schicht mit den lichtdurchlässigen und lichtundurchlässigen Bereichen wird auch als Parallaxbarriereschicht bezeichnet. Die Parallaxbarriereschicht kann dadurch gebildet sein, dass auf einem Teil der Rückseite der Frontscheibe, die der Bilddarstellungsmatrix zugewandt ist, ein lichtundurchlässiges Material aufgebracht ist, sodass auf der Rückseite lichtundurchlässige Bereiche und lichtdurchlässige Bereiche gebildet sind. Der Begriff "Parallaxbarriereschicht" bezeichnet somit nicht unbedingt eine von der Frontscheibe wieder ablösbare Schicht (wie beispielsweise eine optisch aktive Folie, die auf die Scheibe aufgebracht ist) sondern auch eine Raumebene mit lichtundurchlässigen Bereichen und lichtdurchlässigen Bereichen.

In einer Ausführungsform der Erfindung weisen die Befestigungselemente Justiermittel auf, damit die Frontscheibe parallel zur Ebene der Bilddarstellungsmatrix verschiebbar und/oder verdrehbar ist. Mit solchen Justiermitteln kann insbesondere eine Frontscheibe für 3D-Displays in eine gewünschte Position relativ zur Bilddarstellungsmatrix gebracht werden. Ein Beispiel für ein Justiermittel ist eine Schraube, die in einer Öffnung des Befestigungsmittels mit Innengewinde eingeführt ist und in Richtung Frontscheibe aus dem Befestigungselement herausdrehbar, und umgekehrt wieder in das Befestigungselement hineindrehbar ist. Die Schraube kann mit dem ihrem Kopf gegenüberliegenden Ende beispielsweise am Rand der Frontscheibe anliegen, sodass beim Drehen der Schraube die Frontscheibe verschoben wird. Die Schraube kann direkt an der Frontscheibe anliegen oder es können zwischen Schraube und Frontscheibe Zwischenelemente, wie beispielsweise Zwischenplatten oder Streifen, insbesondere aus verformbarem Material, vorhanden sein, sodass die Schraube direkt oder indirekt an der Frontscheibe anliegen kann.

In einer Ausführungsform der Erfindung wird eine Bildwiedergabeanordnung angegeben, aufweisend Profilleisten, die entlang der Ränder der Bilddarstellungsmatrix angeordnet sind, wobei jede Profilleiste eine Auflagefläche für die Frontscheibe aufweist, die parallel zur Ebene der Bilddarstellungsmatrix angeordnet ist, und wobei die Befestigungselemente an den Profilleisten angebracht oder als integraler Bestandteil an den Profilleisten ausgeformt sind. Die Befestigungselemente haben insbesondere die Form einer Flanke, die gegenüber den übrigen Teilen oder Bereichen der Profilleiste seitlich und nach vorn in Blickrichtung des Betrachters hervorspringt.

Die Profilleisten dienen als Aufnahme für die Frontscheibe. Die Auflagefläche für die Frontscheibe ist vorzugsweise an einer dem Betrachter zugewandten Stirnseite der Profilleiste angeordnet.

Jedes Befestigungselement ragt vorzugsweise über einen Rand der Profilleiste quer zur Blickrichtung eines Betrachters hinaus, und springt über die Auflagefläche für die Frontscheibe in Blickrichtung des Betrachters hervor. Jedes Befestigungselement ragt vorzugsweise auch über die übrigen Teile der Profilleiste quer zur Blickrichtung eines Betrachters hinaus. Insbesondere ragt jedes Befestigungselement über einen Rand der Profilleiste heraus, der parallel zum Rand der Bilddarstellungsmatrix verläuft.

Vorzugsweise entspricht die Länge der Profilleiste der Länge des Randes oder im Wesentlichen der Länge des Randes, an dem sie angeordnet ist, sodass die Profilleisten jeweils entlang der gesamten Länge eines Randes angeordnet sind.

Die Profilleisten können beispielsweise an einem Gehäuse einer Bilddarstellungsmatrix befestigt sein, z.B. durch eine Schraub-, Steck- oder Klebverbindung. Die Profilleiste kann einen Rand aufweisen, der sich parallel entlang des Randes der Bilddarstellungsmatrix erstreckt.

Die Profilleisten können so ausgestaltet sein, dass sie die Ränder der Bilddarstellungsmatrix aus Sicht des Betrachters teilweise oder ganz überdecken. Anders ausgedrückt können sie nach innen in Richtung bilddarstellende Fläche ragen, vorzugsweise ohne Teile der bilddarstellenden Fläche zu verdecken. Das nach innen ragende Maß wird vorzugsweise so gewählt, dass die Bilddarstellungsmatrix nicht beeinträchtigt wird, insbesondere keine Matrixelemente der Bilddarstellungsmatrix von der Profilleiste verdeckt werden.

Die Größe der Frontscheibe und/oder die Anordnung der Befestigungselemente ist vorzugsweise so gewählt, dass die von den Befestigungselementen umgrenzte Fläche größer ist als die Fläche der Frontscheibe, so dass es möglich ist, die Scheibe um die Z-Achse verdrehen zu können, um sie relativ zur Bilddarstellungsmatrix ausrichten zu können. Wenn z.B. bei einer Scheibe mit einer Größe von 1340x760 mm eine Verdrehung von 0,5° ermöglicht werden soll, so sollte die von den Befestigungselementen umgrenzte Fläche eine Größe von mindestens ca. 1347x772mm aufweisen. Die Größe der Scheibe und/oder die Anordnung der Befestigungselemente ist vorzugsweise auch so gewählt, dass es möglich ist, die Scheibe auf der X und/oder Y-Achse verschieben zu können, um sie relativ zur Bilddarstellungsmatrix ausrichten zu können.

Der Begriff "von Befestigungselementen umgrenzte Fläche" bedeutet nicht zwingend, dass die Befestigungselemente diese Fläche lückenlos umranden. Gemeint ist eine Fläche, die zumindest teilweise von Befestigungselementen umgrenzt wird, und innerhalb derer die Frontscheibe um die Z-Achse (Blickrichtung des Betrachters) verdrehbar und/oder um die X und Y-Achse verschiebbar ist. Ein Teil der umgrenzten Fläche ist als Auflagefläche ausgestaltet. Beim Verdrehen und beim Verschieben wird die Frontscheibe auf der Auflagefläche der Profilleisten verdreht und/oder verschoben.

Die Profilleisten weisen in einer Ausführungsform Abstandhalter auf, durch welche die Frontscheibe von der Bilddarstellungsmatrix beabstandet positionierbar ist. Die Abstandhalter können ein Teil der Befestigungselemente an den Profilleisten sein, oder sie können an einem anderen Ort an den Profilleisten angeordnet sein. Vorzugsweise sind die Auflageflächen für die Frontscheibe jeweils an der Stirnseite eines Abstandhalters angeordnet. Die Länge der Abstandhalter in Richtung des Benutzers (Z-Achse) ist so gewählt, dass die dem gewünschten Abstand zwischen der Bilddarstellungsmatrix und der Frontscheibe entspricht. Der gewünschte Abstand ist beispielsweise vom Typ der Bilddarstellungsmatrix, dem Anwendungsgebiet und der Nutzeranforderung abhängig.

In einer Ausführungsform weisen die Profilleisten Befestigungselemente mit Klemmelementen auf, wobei die Klemmelemente einen Anpressdruck auf die Frontscheibe in Richtung der Bilddarstellungsmatrix ausüben. Die Klemmelemente sind an den Befestigungselementen anbringbar und üben einen Anpressdruck auf die Frontscheibe in Richtung der Bilddarstellungsmatrix bzw. in Blickrichtung des Betrachters aus. Die Klemmelemente sind vorzugsweise lösbar, um eine Scheibe einsetzen bzw. einklemmen zu können und in einen klemmenden Zustand überführbar, in dem die Frontscheibe festgeklemmt und fixiert ist. Das Klemmelement kann beispielsweise eine Klemmleiste sein, die an der Profilleiste, insbesondere dem Befestigungselement, angebracht wird, z.B. mit einer Schraubverbindung, und die die Frontscheibe gegen ihre Auflagefläche an der Profilleiste presst.

Ebenso wie die Befestigungselemente sind die Klemmelemente, als Teil der Befestigungselemente, so ausgestaltet, dass sie sich bei einer Anordnung von mehreren Bildwiedergabeanordnungen nebeneinander und/oder übereinander nicht direkt gegenüberliegen, sondern vielmehr abwechselnd, gegeneinander versetzt, angebracht sind, sodass die auftragende Dicke der Befestigungen zwischen zwei benachbarten Bildwiedergabeanordnungen nur einmalig zur Verbreiterung des Übergangs zwischen zwei Bilddarstellungsmatrices beiträgt (unsymmetrische Anordnung an den beiden gegenüberliegenden Seiten einer Bilddarstellungsmatrix)

An den Profilleisten, insbesondere auf den Auflageflächen für die Frontscheibe und an den Klemmelementen, kann ein rutschhemmendes Material angebracht sein, um für einen festen Sitz der Frontscheibe zu sorgen. An sich loses rutschhemmendes Material kann auch zwischen die Scheibe und die Profilleiste eingelegt werden.

Die Profilleisten können so gestaltet sein, dass sie mehrere an der Außenseite angebrachte Flanken als Befestigungselemente aufweisen, deren Höhe vorzugsweise das Maß der Profile um die Dicke der Scheibe zzgl. dem rutschhemmenden Material, sofern ein solches vorhanden ist, überschreitet. Die Flanken dienen einerseits als Außenabgrenzung für die Scheibenpositionierung, andererseits als Befestigungspunkt für darauf zu befestigenden Klemmelemente, Außerdem können ein den Flanken Justierelemente für die Scheibe angeordnet sein, die oben beschrieben wurden.

In einer Ausführungsform sind haben die Befestigungselemente, die an den Profilleisten anbringbar sind eine L-Form (Winkel) wobei das Befestigungselement mit einem ersten Schenkel des L, vorzugsweise einem längeren Schenkel, an der Profilleiste seitlich angebracht wird, sodass dieser längere Schenkel eine seitliche Flanke bildet. Beispielsweise kann der längere Schenkel an der Profilleiste angeschraubt oder angeklebt sein. Der andere, zweite Schenkel des L, vorzugsweise ein kürzerer Schenkel übt einen Anpressdruck auf die Frontscheibe in Richtung der Bilddarstellungsmatrix aus. Der zweite Schenkel liegt von Außen an der Frontscheibe an und presst die Frontscheibe gegen das Profil, d.h. gegen die Auflagefläche an dem Profil. Der längere, seitliche Schenkel wird vorzugsweise am Profil angeschraubt und weist beispielsweise ein Langloch auf, sodass er entlang seiner Befestigungsstelle verschiebbar ist, wodurch er in eine solche Position gebracht werden kann, dass er die Frontscheibe in der oben dargestellten Art und Weise anpresst. Das Befestigungselement ist somit vorzugsweise von der Profilleiste lösbar, also reversibel anbringbar, und vorzugsweise zumindest relativ zur Profilleiste entlang der Blickachse des Betrachters verschiebbar. Zwischen dem zweiten Schenkel und der Frontscheibe kann ein weiches, rutschhemmendes Material angeordnet sein. Ebenso kann zwischen der Profilleiste und der Frontscheibe ein weiches rutschhemmendes Material angeordnet sein. Wenn zwischen der Profilleiste und der Frontscheibe ein solches Material angeordnet ist, dann bildet eine Oberfläche des Materials eine Auflagefläche für die Frontscheibe, wenn man das Material als Teil der Profilleiste betrachtet. Oder dieses Material liegt auf der Auflagefläche der Profilleiste auf, und kann als Teil der Frontscheibe betrachtet werden.

In einer Ausführungsform sind entlang gegenüberliegender, vorzugsweise gleichlanger, Ränder der Bilddarstellungsmatrix identische Profilleisten angeordnet. Die Profilleisten sind zueinander punktsymmetrisch um einen Punkt angeordnet, der auf der Schnittstelle der beiden Diagonalen der rechteckigen Bilddarstellungsmatrix liegt. Anders ausgedrückt sind einander an einer Bilddarstellungsmatrix gegenüberliegende Profilleisten zueinander um 180° um die Z-Achse verdreht. Diese Ausführungsform ist besonders bei einer rechteckigen Bilddarstellungsmatrix vorteilhaft. Bei einer rechteckigen Bilddarstellungsmatrix gibt es die Profilleisten und die daran anbringbaren Klemmelemente nur in zwei Ausführungen, eine längere Ausführung für die gegenüberliegenden Längsseiten der Matrix und eine kurze Ausführung für die gegenüberliegenden Breitseiten der Matrix.

Schließlich betrifft die Erfindung auch eine Anordnung aus mehreren Bildwiedergabeanordnungen wie zuvor beschrieben, wobei mehrere Bildwiedergabeanordnungen nebeneinander und/oder übereinander angeordnet sind, sodass die einzelnen Bilddarstellungsmatrices der Bildwiedergabeanordnungen zu einer vergrößerten Bilddarstellungsmatrix zusammengesetzt sind. Die Zusammensetzung und Anordnung der Befestigungselemente bei benachbarten Bildwiedergabeanordnungen erfolgt nach den zuvor beschriebenen Prinzipien.

Nachfolgend wird die Erfindung anhand spezieller Ausführungsformen beschrieben es zeigen:
- Fig. 1: eine Frontansicht eines Teils einer rechteckigen Bilddarstellungsmatrix mit umlaufenden Rändern;
- Fig. 2: eine Frontansicht nach Fig. 1 mit montierten Profilleisten;
- Fig. 3: eine Frontansicht mit montierten Profilleisten wie in Fig. 2 und einer aufgelegten Frontscheibe;
- Fig. 4: eine Ansicht nach Fig. 3, wobei die Frontscheibe mit Klemmleisten befestigt ist;
- Fig. 5: den Zusammenbau nach ähnlich zu Fig. 2 aus einer Perspektive schräg von der Seite;
- Fig. 6: den Zusammenbau nach Fig. 4 aus einer Perspektive schräg von der Seite;
- Fig. 7: einen Ausschnitt aus einer Bildwiedergabeanordnung in einer Betrachtung von schräg oben;
- Fig. 8: einen Ausschnitt aus einer Bildwiedergabeanordnung analog zu Fig. 6, bei Betrachtung von oben oder unten (Y-Richtung) ;
- Fig. 9: eine alternative Ausführungsform einer Profilleiste mit L-förmigem Befestigungselement in einer Betrachtung von schräg oben;
- Fig. 10: eine alternative Ausführungsform einer Profilleiste mit L-förmigem Befestigungselement in einer Betrachtung von oben oder unten (Y-Richtung);
- Fig. 11: einen Ausschnitt aus einer Anordnung aus mehreren Bildwiedergabeanordnungen in einer Frontansicht; und
- Fig. 12: einen weiteren Ausschnitt aus einer Anordnung aus mehreren Bildwiedergabeanordnungen, wobei eine Bildwiedergabeanordnung vollständig gezeigt ist.

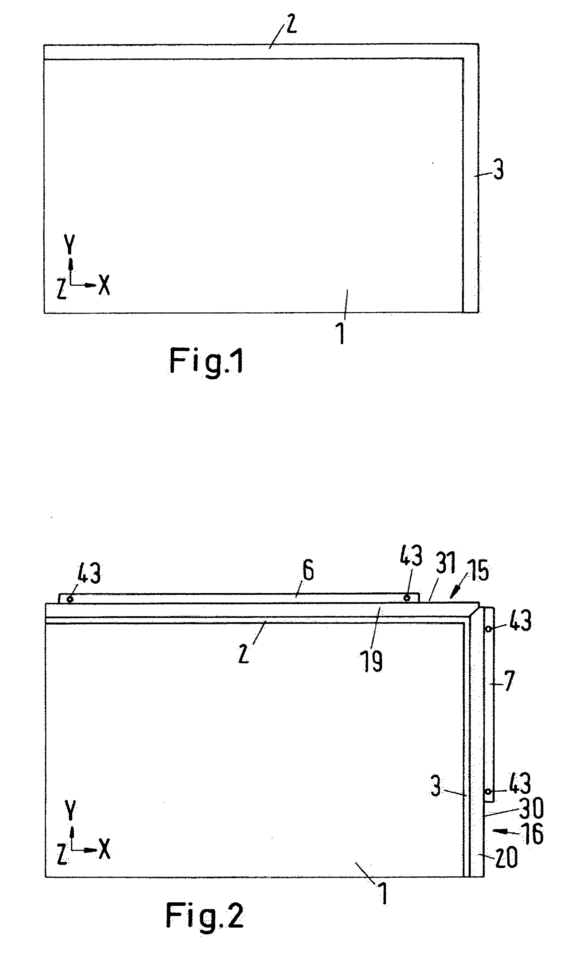

Die Fig. 1 zeigt den Blick des Betrachters auf eine Bilddarstellungsmatrix 1. Der Blick des Betrachters ist in z-Richtung und die x-Richtung und y-Richtung sind links unten in der Fig. 1 eingezeichnet. Gezeigt ist ein Ausschnitt aus einer rechteckigen Bilddarstellungsmatrix 1 im Bereich der rechten oberen Ecke. Die Bilddarstellungsmatrix 1 wird von den Rändern 2, 3 und den nicht gezeigten Rändern 4 (liegt gegenüber Rand 2 und verläuft parallel zu Rand 2) und 5 (liegt parallel zu Rand 3 und gegenüber Rand 3) umrandet. Die Ränder 2, 3, 4, 5 sind Teil eines Gehäuses der Bilddarstellungsmatrix 1.

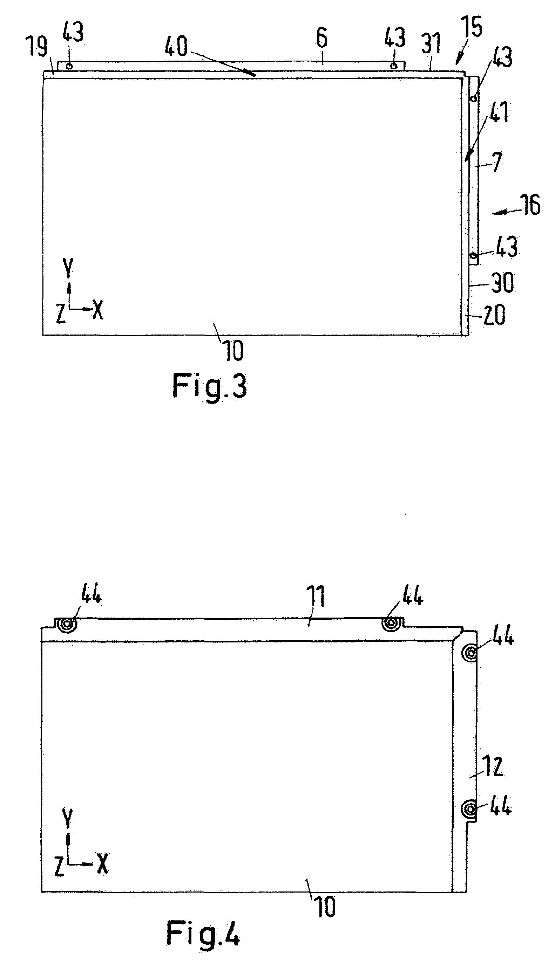

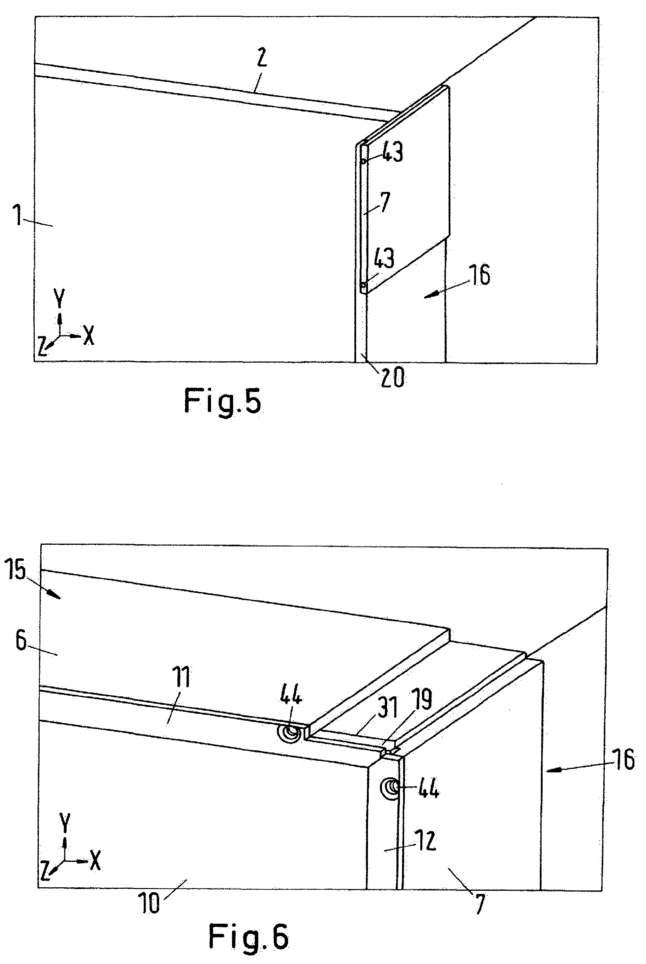

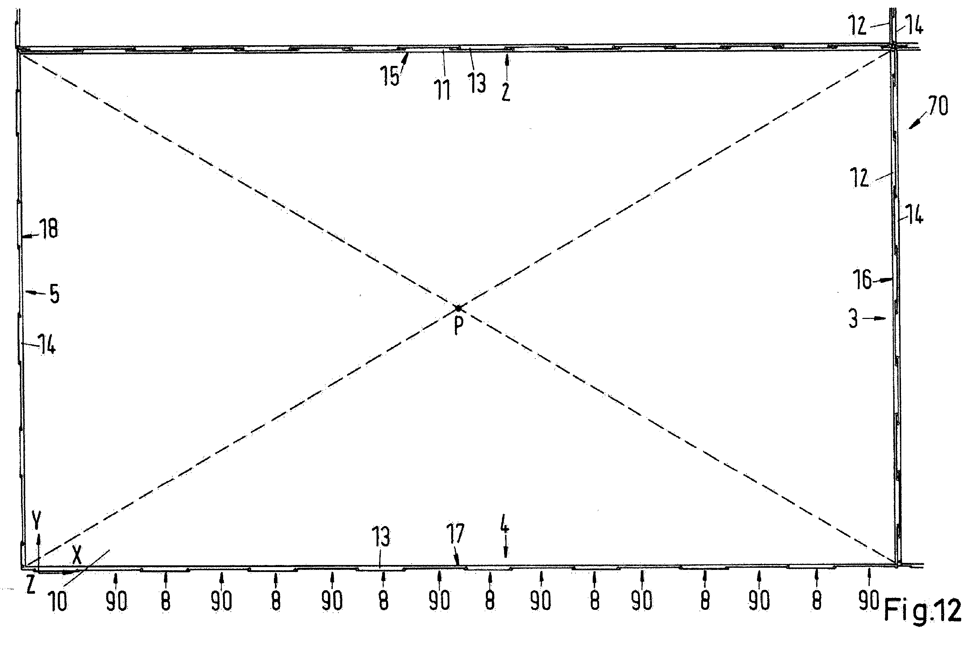

Die Fig. 2 zeigt an den Rändern 2 und 3 angeordnete Profilleisten 15, 16, wobei auch die Profilleisten nur ausschnittweise gezeigt sind. Weitere Profilleisten 17, 18 sind jeweils an den Rändern 4, 5 angeordnet (nicht gezeigt, siehe aber Fig. 12). Die Profilleiste 15 weist eine Auflagefläche 19 auf und die Profilleiste 16 eine Auflagefläche 20, die dem Betrachter zugewandt sind und auf die eine Frontscheibe gelegt werden kann (siehe Fig. 3). Die Profilleisten 15, 16 bzw. deren Auflageflächen 19, 20 verdecken teilweise die Ränder 2 und 3, wie im Vergleich mit der Fig. 1 erkennbar ist. Ein Befestigungselement 6 ist an der Profilleiste 15 ausgeformt und ein Befestigungselement 7 ist an der Profilleiste 16 ausgeformt. Die Profilleisten 15, 16 weisen weitere Befestigungselemente auf, die in dieser Abbildung, die nur einen Ausschnitt darstellt, nicht gezeigt sind. Das Befestigungselement 6 springt zum Betrachter hin über die Ebene der Bilddarstellungsmatrix 1 hervor. Das Befestigungselement 6 springt auch über die Auflagefläche 19 in Richtung des Betrachters hervor. Das Befestigungselement 7 springt zum Betrachter hin über die Ebene der Bilddarstellungsmatrix 1 hervor. Das Befestigungselement 7 springt auch über die Auflagefläche 20 in Richtung des Betrachters (aus der Bildebene hinaus) hervor (vgl. Fig. 5).

Die Fig. 5 zeigt eine seitliche Ansicht auf den Zusammenbau nach Fig. 2, mit der Profilleiste 16, aber ohne die Profilleiste 15. Anhand der Profilleiste 16 ist erkennbar, dass das Befestigungselement 7 eine in z-Richtung hervorstehende Flanke ist, die sich vom Rest der Profilleiste 16 abhebt. Wie in den Fig. 2 und 5 erkennbar, ragt das Befestigungselement 7 quer zur Blickrichtung des Betrachters (der z-Richtung) in x-Richtung über den Rand 3 der Bilddarstellungsmatrix 1 heraus. In analoger Weise ragt das Befestigungselement 6, das ebenfalls als seitliche Flanke der Profilleiste 15 ausgebildet ist, in x-Richtung über den Rand 2 hervor. Auch weitere Teile der Profilleisten 15, 16 ragen über die Ränder 2, 3 hervor, aber die Befestigungselemente 6, 7 ragen weiter in x-Richtung bzw. y-Richtung hervor als die übrigen Teile der Profilleisten 15, 16. Die Profilleiste 15 weist einen Rand 31 auf, der parallel zum Rand 2 der Bilddarstellungsmatrix verläuft. Das Befestigungselement 6 ragt in y-Richtung über diesen Rand 31 hervor. Die Profilleiste 16 weist einen Rand 30 auf, der parallel zum Rand 2 der Bilddarstellungsmatrix verläuft. Das Befestigungselement7 ragt in x-Richtung über den Rand 30 hervor.

Die Fig. 3 zeigt den Aufbau der Fig. 2, mit dem Unterschied, dass eine Frontscheibe 10 auf die Auflageflächen 19, 20 der Profilleisten 15, 16 und die Auflageflächen 21, 22 der Profilleisten 17, 18 (nicht gezeigt) aufgelegt ist. Die Bilddarstellungsmatrix 1 und die Ränder 2, 3 und die nicht dargestellten Ränder 4, 5 sind von der Frontscheibe 10 vollständig verdeckt. Die Auflageflächen 19, 20, 21, 22 sind teilweise von der Frontscheibe verdeckt. Zwischen der Frontscheibe 10 und dem Befestigungselement 6 ist ein Spalt 40 gebildet und zwischen der Frontscheibe 10 und dem Befestigungselement 7 ein Spalt 41. Daher ist die Frontscheibe 10 in x- und y-Richtung verschiebbar, wobei die x- und y-Richtung im links unten dargestellten Koordinatensystem gezeigt sind. Ebenso ist die Frontscheibe um eine z-Achse drehbar, wenn Spalten zwischen der Frontscheibe und den Befestigungselementen vorhanden sind.

Die Befestigungselemente 6 und 7 weisen Gewindelöcher 43 auf. In Fig. 4 ist dargestellt, wie eine Klemmleiste 11 an dem Befestigungselement 6 angebracht ist. Die Klemmleiste 11 ist mit Schrauben (nicht dargestellt) fixiert, die durch Öffnungen 44 der Klemmleiste 11 geführt sind und die in die Gewindelöcher 43 des Befestigungselements 6 eingeschraubt sind. Die Klemmleiste 11 presst die Frontscheibe 10 gegen die Auflagefläche 19. Da die Löcher 44 konisch geformt sind, können Senkschrauben verwendet werden, die im eingedrehten Zustand bündig mit der Oberfläche der Klemmleiste 11 abschließen. Auf gleiche Art und Weise ist die Klemmleiste 12, welche die Frontscheibe 10 gegen die Auflagefläche 20 presst, an dem Befestigungselement 7 befestigt. Nicht gezeigte weitere Klemmleisten 13 und 14 sind an nicht gezeigten Befestigungselementen 8 und 9 befestigt, welche an Profilleisten 17 und 18 vorgesehen sind.

Die Fig. 6 zeigt einen Ausschnitt aus der Fig. 4 in einer etwas gedrehten Perspektive zur besseren Veranschaulichung des dreidimensionalen Aufbaus. Man erkennt, wie auch in der Fig. 5, die Ausdehnung der Profilleisten 15 und 16 in z-Richtung.

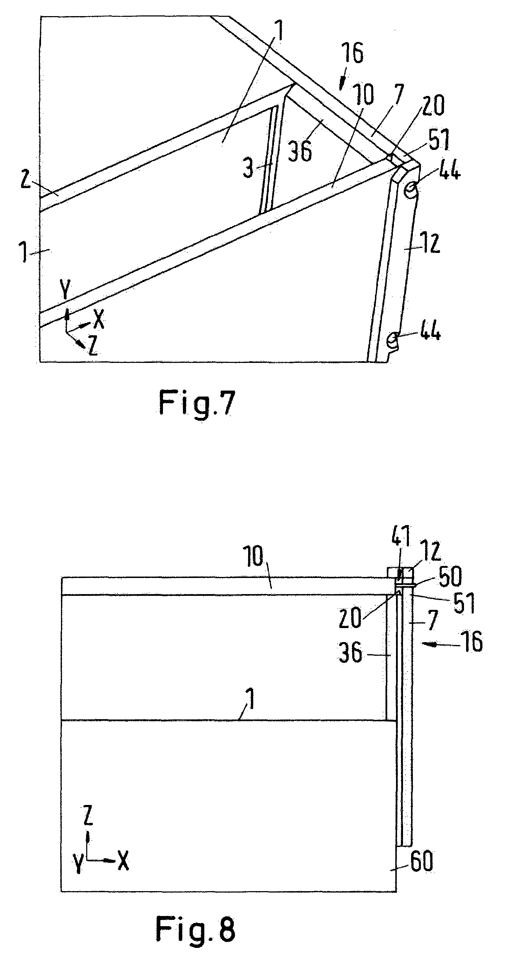

In der Fig. 7 ist eine weitere Ansicht auf die Anordnung von schräg oben gezeigt, wobei die Profilleiste 15 sowie die Klemmleiste 11 weggelassen sind, um den Ausbau besser zu veranschaulichen.

Die Fig. 8 zeigt einen Blick in y-Richtung auf den Aufbau der Fig. 7. In den Fig. 7 und 8 ist wiederum die räumliche Ausdehnung der Profilleiste 16 in z-Richtung erkennbar. Das Befestigungselement 7 weist einen Abstandhalter 36 auf, der an das Befestigungselement 7, die eine seitlich hervorstehende Flanke ist, angrenzt. Der Abstandhalter 36 verdeckt teilweise den Rand 3 der Bilddarstellungsmatrix 1. In der speziellen Ausführungsform erstreckt sich der Abstandhalter 36 entlang des gesamten Randes 3 bzw. über die gesamte Länge der Profilleiste (vgl. Fig. 5), so dass der Abstandhalter 36 nicht nur im Bereich des Befestigungselements 7 angeordnet ist. An der Stirnseite des Abstandhalters 36 ist die Auflagefläche 20 für die Frontscheibe 10 angeordnet. In der Fig. 8 ist eine Madenschraube 50 gezeigt, welche ein sich verjüngendes Ende 51 des Befestigungselements 7 durchdringt und am Rand der Frontscheibe 10 anliegt. Mit der Madenschraube 50 bzw. mit mehreren an den Befestigungselementen 6, 7, 8, 9 auf gleicher Art und Weise angeordneten Madenschrauben 50 kann die Frontscheibe 10 in x-Richtung und y-Richtung justiert werden, da zwischen der Frontscheibe 10 und dem Befestigungselement 7 bzw. dessen sich verjüngenden Ende 51 ein Spalt 41 gebildet ist. Für die Justierung kann sofern erforderlich die Klemmleiste 12 etwas gelockert werden. Zwischen der Madenschraube 50 und der Frontscheibe 10 kann ein Zwischenelement vorgesehen sein, insbesondere aus einem flexiblen, verformbaren Material, um die Frontscheibe 10 vor Beschädigungen durch die Schraube 50 zu schützen. In gleicher Weise kann zwischen der Frontscheibe 10 und der Klemmleiste 12 ein flexibles, vorzugsweise auch rutschhemmendes, Material vorgesehen sein. Auch zwischen der Frontscheibe 10 und der Auflagefläche 20 kann ein flexibles rutschhemmendes Material angeordnet sein.

In der Fig. 8 ist erkennbar, dass die Profilleiste 16 teilweise seitlich am Gehäuse 60 anliegt. Sie kann am Gehäuse 60 auf verschiedene Art und Weise befestigt sein, beispielsweise mit einer Kleb- oder Schraubverbindung.

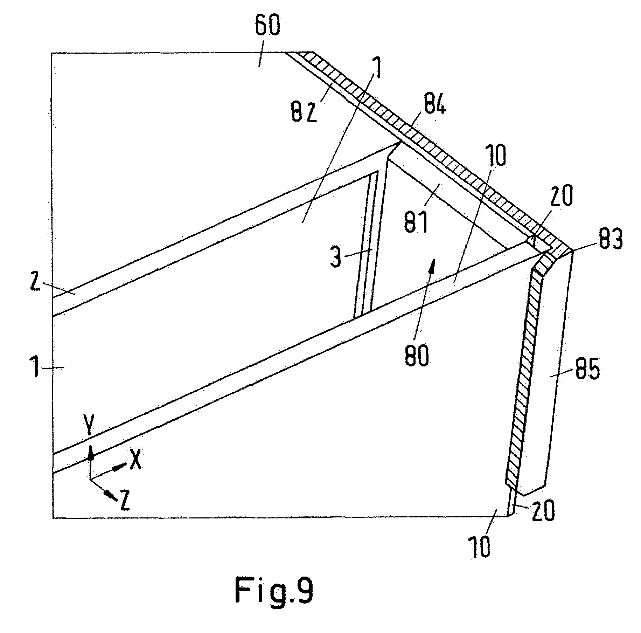

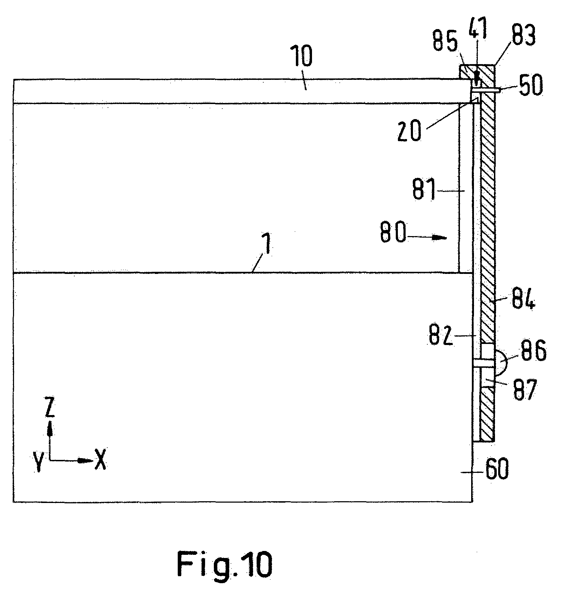

Die Fig. 9 und 10 zeigen aus zwei verschiedenen Perspektiven, von schräg oben und aus Y-Richtung (parallel zur Bilddarstellungsmatrix 1), eine weitere Ausführungsform einer Profilleiste 80. Die Profilleiste 80 hat einen in Z-Richtung hervorstehenden Teil 81, der als Abstandhalter dient, und einen Schenkel 82, der seitlich am Gehäuse 60 der Bilddarstellungsmatrix 1 befestigt ist. Die Teile 81 und 82 sind keine getrennten oder trennbaren Elemente sondern in einem Stück (integral) ausgeformt, beispielsweise aus Kunststoff oder Metall. In dieser Ausführungsform bildet ein Befestigungselement 83 im Gegensatz zur Ausführungsform der Fig. 7 und 8 keinen integralen Bestandteil der Profilleiste, ist also kein ausgeformter Teil des Profils. Stattdessen ist das Befestigungselement 83 als separates Teil an der Profilleiste befestigt, in diesem Fall durch eine Schraubverbindung. Das Befestigungselement 83 hat eine L-Form (Winkel) mit einem ersten längeren Schenkel 84 und einem kürzeren Schenkel 85. Das Befestigungselement 83 ist mit dem ersten Schenkel 84 an der Profilleiste 80 seitlich mit einer Schraube 86 angeschraubt. Der Schenkel 84 weist ein Langloch 87 auf, durch das die Schraube 86 geführt ist. Die Schraube 86 ist in den seitlichen Schenkel 82 der Profilleiste 80 eingedreht. Aufgrund des Langlochs ist der Schenkel 84 in Z-Richtung verschiebbar und kann soweit verschoben werden, dass der kürzere Schenkel 85, der an der Frontscheibe 10 anliegt, die Frontscheibe 10 gegen die Auflagefläche 20 an der Profilleiste presst. Der Schenkel 85 des Befestigungselements 83 übt einen Anpressdruck auf die Frontscheibe 10 in Richtung der Bilddarstellungsmatrix 1 aus und sichert die Frontscheibe in ihrer Position. Der längere Schenkel 84 bildet eine seitliche Flanke und Begrenzung für die Frontscheibe.

In der Fig. 10 ist eine Madenschraube 50 gezeigt, welche den Schenkel 84 des Befestigungselements 83 durchdringt und am Rand der Frontscheibe 10 anliegt. Mit der Madenschraube 50 kann die Frontscheibe 10 in x-Richtung (oder bei anderen Befestigungselementen, die gegenüber dem Element 83 um 90° gedreht sind, in y-Richtung) justiert werden, da zwischen der Frontscheibe 10 und dem Schenkel 84 ein Spalt 41 gebildet ist. Für die Justierung kann sofern erforderlich die Schraube 86 etwas gelockert werden. Zwischen der Madenschraube 50 und der Frontscheibe 10 kann ein Zwischenelement vorgesehen sein, insbesondere aus einem flexiblen, verformbaren Material, um die Frontscheibe 10 vor Beschädigungen durch die Schraube 50 zu schützen. Zwischen dem Schenkel 85 und der Frontscheibe kann ein weiches, rutschhemmendes Material angeordnet sein. Ebenso kann zwischen der Profilleiste und der Frontscheibe ein weiches rutschhemmendes Material angeordnet sein.

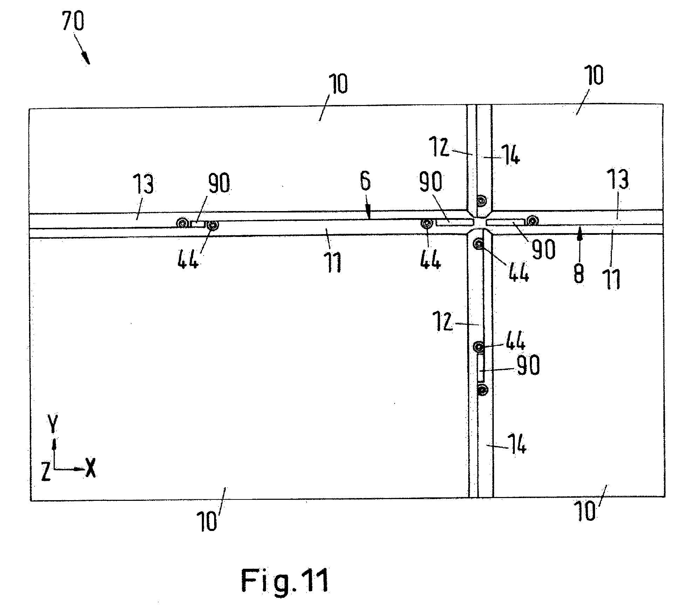

Ausgehend vom gezeigten Ausschnitt einer Bildwiedergabeanordnung der Fig. 4 zeigt die Fig. 11 einen Zusammenbau 70 aus mehreren Bildwiedergabeanordnungen, wobei vier Bildwiedergabeanordnungen gezeigt sind, die eine rechteckige Form haben und an einer gemeinsamen Ecke zusammenstoßen und deren Ränder parallel zueinander angeordnet sind.

Die Fig. 12 zeigt einen vergrößerten Ausschnitt, wobei eine der Bildwiedergabeanordnungen im linken unteren Bereich der Fig. 12 vollständig gezeigt ist. Bei allen Bildwiedergabeanordnungen sind die Befestigungselemente von Klemmleisten 11, 12, 13, 14 verdeckt, wobei die Befestigungselemente jeweils hinter den Vorsprüngen der Klemmleisten 11, 12, 13, 14 angeordnet sind, erkennbar an den Bereichen zwischen den Löchern 44. In der Fig. 12 ist gut erkennbar, dass die Befestigungselemente entlang der Ränder (verdeckt) so angeordnet sind, dass zwischen Befestigungselementen Aussparungen 90 vorhanden sind. Beispielhaft ist dies gezeigt am unteren Rand der vollständig dargestellten Bildwiedergabeanordnung in Fig. 12 links unten, wo Aussparungen 90 zwischen Befestigungselementen 8 gebildet sind, wobei die Befestigungselemente 8 wiederum durch die Klemmleiste 13 verdeckt sind. Auch die Klemmleiste 13 weist entsprechende Aussparungen auf bzw. bildet die Form der Aussparungen 90 nach. Die Aussparung 90 rechts unten in der Fig. 12 grenzt an das Befestigungselement 8 an und ist nicht zwischen zwei Befestigungselementen 8 angeordnet.

In der Fig. 11 ist erkennbar, dass das hinter der Klemmleiste 11 angeordnete Befestigungselement 6 (vgl. mit Fig. 3) in die Aussparung 90 eingreift. In analoger Weise greifen weitere Befestigungselemente, die entlang des gleichen oder anderer Ränder angeordnet sind, in Aussparungen 90 ein. Die Aussparungen 90 sind in dieser Ausführungsform breiter als die Befestigungselemente bzw. die die Befestigungselemente abbildenden Vorsprünge der Klemmleisten, so dass die einzelnen Anordnungen etwas gegeneinander verschiebbar sind. Dadurch, dass die Befestigungselemente und die vorspringenden Teile der Klemmleiste 11, 12, 13, 14 jeweils in eine zugeordnete Aussparung 90 eingreifen, ist die Gesamtbreite des Übergangs (Steges) zwischen zwei Bilddarstellungsmatrices minimiert.

Betrachtet aus der z-Richtung entsprechen die Formen der Klemmleisten 11, 12, 13, 14 den Formen der von ihnen verdeckten Profilleisten 15, 16, 17, 18. Die Ränder 2, 3, 4, 5, die von den Profilleisten 15, 16, 17, 18 und den Klemmleisten 11, 12, 13, 14 verdeckt sind, sind in der Fig. 12 mit Pfeilen angedeutet und mit 2, 3, 4, 5 bezeichnet. An gegenüberliegenden Rändern 2 und 4 angeordnete Profilleisten 15 und 17 sind zueinander punktsymmetrisch um den Punkt P angeordnet, der auf der Schnittstelle der breiten Diagonalen der rechteckigen Bilddarstellungsmatrix 1, hier verdeckt durch die Frontscheibe 10, liegt. In analoger Weise sind die Profilleisten 16 und 18 und die Klemmleisten 12 und 14 zueinander punktsymmetrisch angeordnet. Dies bedeutet, dass die Klemmleisten 11 und 13 identisch sind, die Klemmleisten 12 und 14 identisch sind, die Profilleisten 15 und 17, die von den Klemmleisten 11 und 13 verdeckt werden, zueinander identisch sind, und die Profilleisten 16 und 18, die von den Klemmleisten 12 und 14 verdeckt werden, zueinander identisch sind. Da die an gegenüberliegenden Rändern angeordneten Profilleisten zueinander punktsymmetrisch angeordnet sind, sind auch die an den Profilleisten vorgesehenen Befestigungselemente zueinander punktsymmetrisch zum Punkt P angeordnet.

## Patentansprüche

1. Bildwiedergabeanordnung, aufweisend
- eine zweidimensionale, Bilddarstellungsmatrix (1), die von Rändern (2,3,4,5) umgrenzt ist und durch deren Matrixelemente Bilder darstellbar sind,
- angrenzend zu den Rändern der Bilddarstellungsmatrix angebrachte Befestigungselemente (6,7,8,9; 83),
- eine Frontscheibe (10), die an den Befestigungselementen befestigt ist und in einer Ebene vor der Bilddarstellungsmatrix (1) fixiert ist,
wobei die Befestigungselemente (6,7,8,9; 83)
- mindestens teilweise über die Ebene der Bilddarstellungsmatrix hervorspringen,
- mindestens teilweise einen über den Rand (2,3,4,5) der Bilddarstellungsmatrix quer zur Blickrichtung eines Betrachters hervorspringen,
- Klemmelemente (11,12,13,14) aufweisen und einen Anpressdruck auf die Frontscheibe in Richtung der Bilddarstellungsmatrix (1) ausüben,
wobei die Befestigungselemente (6, 7, 8, 9; 83) entlang der Ränder so angeordnet sind, dass
- zwischen Befestigungselementen und/oder angrenzend zu einem oder mehreren Befestigungselementen Aussparungen (90) vorhanden sind,
und bei einer Anordnung mehrerer solcher Bildwiedergabeanordnungen neben- und/oder übereinander
- die Befestigungselemente (6, 7, 8, 9; 83) einer ersten Bildwiedergabeanordnung in den Aussparungen (90) einer oder mehrerer zur ersten Bildwiedergabeanordnung benachbarter Bildwiedergabeanordnungen positionierbar sind und
- die Befestigungselemente (6, 7, 8, 9; 83) einer oder mehrerer zur ersten Bildwiedergabeanordnung benachbarter Bildwiedergabeanordnungen in den Aussparungen (90) der ersten Bildwiedergabeanordnung positionierbar sind.

2. Bildwiedergabeanordnung nach Anspruch 1, bei der an gegenüberliegenden Rändern (2/4, 3/5) angeordnete Befestigungselemente zueinander punktsymmetrisch um einen Punkt (P) angeordnet sind, der auf der Schnittstelle der beiden Diagonalen der rechteckigen Bilddarstellungsmatrix (1) liegt.

3. Bildwiedergabeanordnung nach Anspruch 1 oder 2, bei der die Befestigungselemente (83) L-förmig ausgestaltet sind, wobei ein Schenkel (84) des L-förmigen Befestigungselements an der Seite des Gehäuses (60) der Bilddarstellungsmatrix (1) angebracht ist, wobei er direkt oder indirekt an dem Gehäuse anliegt, und ein zweiter Schenkel (85) direkt oder indirekt an der Frontscheibe (10) anliegt und einen Anpressdruck auf die Frontscheibe (10) in Richtung der Bilddarstellungsmatrix (1) ausübt.

4. Bildwiedergabeanordnung nach einem der vorangehenden Ansprüche, die Abstandhalter (36; 81) aufweist, durch welche die Frontscheibe (10) von der Bilddarstellungsmatrix (1) beabstandet positionierbar ist.

5. Bildwiedergabeanordnung nach einem der vorangehenden Ansprüche, bei welcher die Befestigungselemente (6, 7, 8, 9; 83) Justiermittel (50) aufweisen, womit die Frontscheibe (1) parallel zur Ebene der Bilddarstellungsmatrix (1) verschiebbar und/oder verdrehbar ist.

6. Bildwiedergabeanordnung nach einem der vorangehenden Ansprüche, aufweisend Profilleisten (15,16,17,18; 80), die entlang der Ränder (2,3,4,5) der Bilddarstellungsmatrix (1) angeordnet sind, wobei jede Profilleiste (15,16,17,18; 80) eine Auflagefläche (19,20,21,22) für die Frontscheibe (10) aufweist, die parallel zur Ebene der Bilddarstellungsmatrix (1) angeordnet ist, und wobei die Befestigungselemente (6,7,8,9; 83) an den Profilleisten (15,16,17,18) angebracht oder als integraler Bestandteil an den Profilleisten ausgeformt sind.

7. Bildwiedergabeanordnung nach Anspruch 6, bei der die Profilleisten Befestigungselemente (6,7,8,9; 83) mit Klemmelementen (11,12,13,14) aufweisen, wobei die Klemmelemente einen Anpressdruck auf die Frontscheibe in Richtung der Bilddarstellungsmatrix (1) ausüben.

8. Bildwiedergabeanordnung nach Anspruch 6, bei der die die Profilleisten (80) Befestigungselemente (83) aufweisen, die L-förmig ausgestaltet sind, wobei ein Schenkel (84) des L-förmigen Befestigungselements seitlich an der Profilleiste (80) angebracht ist, und ein zweiter Schenkel (85) an der Frontscheibe (10) anliegt und einen Anpressdruck auf die Frontscheibe (10) in Richtung der Bilddarstellungsmatrix (1) ausübt.

9. Bildwiedergabeanordnung nach einem der Ansprüche 6-8, bei der an gegenüberliegenden Rändern (2/4, 3/5) der Bilddarstellungsmatrix (1) jeweils identische, einander gegenüberliegende Profilleisten angeordnet sind.

10. Anordnung (70) aus mehreren Bildwiedergabeanordnungen nach einem der Ansprüche 1-9, wobei mehrere Bildwiedergabeanordnungen nebeneinander und/oder übereinander angeordnet sind, sodass die einzelnen Bilddarstellungsmatrices der Bildwiedergabeanordnungen zu einer vergrößerten Bilddarstellungsmatrix zusammengesetzt sind.

## Claims

1. An image reproduction assembly, comprising
- a two-dimensional image display matrix (1), which is surrounded by edges (2,3,4,5), and images can be presented by their matrix elements,
- fastening elements (6,7,8,9; 83) applied adjacent to the edges of the image display matrix,
- a front screen (10), which is fastened to the fastening elements and fixed in a place in front of the image display matrix (1),
wherein the fastening elements (6,7,8,9; 83)
- protrude at least partially beyond the plane of the image display matrix,
- protrude at least partially beyond the edge (2,3,4,5) of the image display matrix at a right angle to the viewing direction of a viewer,
- exhibit clamping elements (11,12,13,14) and exert a contact pressure on the front screen in the direction of the image display matrix (1),
wherein the fastening elements (6, 7, 8, 9; 83) are arranged along the edges in such a manner that
- between fastening elements and/or adjacent to one or more fastening elements there are recesses (90) present,
and with an arrangement of a plurality of such image reproduction assemblies next to and/or on top of one another
- the fastening elements (6, 7, 8, 9; 83) of a first image reproduction assembly are positionable in the recesses (90) of one or more image reproduction assemblies adjacent to the first image reproduction assembly and
- the fastening elements (6, 7, 8, 9; 83) of one or more image reproduction assemblies adjacent to the first image reproduction assembly are positionable in the recesses (90) of the first image reproduction assembly.

2. An image reproduction assembly according to claim 1, where fastening elements arranged on opposing edges (2/4, 3/5) are arranged to one another point-symmetric about a point (P), which is located at the interface of two diagonals of the rectangular image display matrix (1).

3. An image reproduction assembly according to claim 1 or 2, wherein the fastening elements (83) are designed in an L-shape, wherein one leg (84) of the L-shaped fastening element is attached to the side of the housing (60) of the image display matrix (1), wherein it butts directly or indirectly against the housing, and a second leg (85) butts directly or indirectly against the front screen (10) and exerts a contact pressure on the front screen (10) in the direction of the image display matrix (1).

4. An image reproduction assembly according to one of the preceding claims, which exhibits spacers (36; 81), by which the front screen (10) is positionable, spaced from the image display matrix (1).

5. An image reproduction assembly according to one of the preceding claims, where the fastening elements (6, 7, 8, 9; 83) exhibit adjusting elements (50), with which the front screen (1) is moveable and/or twistable parallel to the plane of the image display matrix (1).

6. An image reproduction assembly according to one of the preceding claims, comprising sectional strips (15,16,17,18 ; 80), which are arranged along the edges (2,3,4,5) of the image display matrix (1), wherein each sectional strip (15,16, 17,18; 80) has a support surface (19,20,21,22) for the front screen (10), which is arranged parallel to the plane of the image display matrix (1), and wherein the fastening elements (6,7,8,9 ; 83) are attached to the sectional strips (15,16,17,18) or molded as an integral part of the sectional strips.

7. An image reproduction assembly according to claim 6, wherein the sectional strips exhibit fastening elements (6,7,8,9; 83) with clamping elements (11,12,13,14), wherein the clamping elements exert a contact pressure on the front screen in the direction of the image display matrix (1).

8. The image reproduction assembly according to claim 6, wherein the sectional strips (80) exhibit fastening elements (83), which are designed in L-shape, wherein a leg (84) of the L-shaped fastening element is attached to the side of the sectional strip (80), and a second leg (85) butts against the front screen (10) and exerts a contact pressure on the front screen (10) in the direction of the image display matrix (1).

9. An image reproduction assembly according to one of the claims 6-8, wherein identical sectional strips opposite one another in each case are arranged on opposing edges (2/4, 3/5) of the image display matrix (1).

10. An arrangement (70) of a plurality of image reproduction assemblies according to one of claims 1-9, wherein a plurality of image reproduction assemblies are arranged next to and/or on top of one another such that the individual image display matrices of the image reproduction assemblies are combined to form an enlarged image display matrix.

## Revendications

1. Agencement de reproduction d'images présentant
- une matrice de représentation d'images en deux dimensions (1) qui est délimitée par des bords (2, 3, 4, 5) et par des éléments de matrice de laquelle des images peuvent être représentées,
- des éléments de fixation (6, 7, 8, 9 ; 83) montés de manière contiguë aux bords de la matrice de représentation d'images,
- une vitre frontale (10) qui est fixée sur les éléments de fixation et est fixée dans un plan avant la matrice de représentation d'images (1),
les éléments de fixation (6, 7, 8, 9 ; 83)
- jaillissant au moins en partie du plan de la matrice de représentation d'images,
- jaillissant au moins en partie du bord (2, 3, 4, 5) de la matrice de représentation d'images transversalement au sens d'observation d'un observateur,
- présentant des éléments de serrage (11, 12, 13, 14) et exerçant une pression de serrage sur la vitre frontale en direction de la matrice de représentation d'images (1), les éléments de fixation (6, 7, 8, 9 ; 83) étant agencés le long des bords de sorte que
- des évidements (90) soient présents entre des éléments de fixation et/ou de manière contiguë à un ou plusieurs éléments de fixation,
et pour un agencement de plusieurs tels agencements de reproduction d'images l'un à côté de l'autre et/ou l'un au-dessus de l'autre
- les éléments de fixation (6, 7, 8, 9 ; 83) d'un premier agencement de reproduction d'images pouvant être positionnés dans les évidements (90) d'un ou plusieurs agencements de reproduction d'images contigus au premier agencement de reproduction d'images et
- les éléments de fixation (6, 7, 8, 9 ; 83) d'un ou plusieurs agencements de reproduction d'images contigus au premier agencement de reproduction d'images pouvant être positionnés dans les évidements (90) du premier agencement de reproduction d'images.

2. Agencement de reproduction d'images selon la revendication 1, pour lequel des éléments de fixation agencés sur des bords opposés (2/4, 3/5) sont agencés à symétrie ponctuelle autour d'un point (P) qui se trouve sur l'interface des deux diagonales de la matrice de représentation d'images (1) rectangulaire.

3. Agencement de reproduction d'images selon la revendication 1 ou 2, pour lequel les éléments de fixation (83) sont configurés en forme de L, une branche (84) de l'élément de fixation en forme de L étant montée sur le côté du boîtier (60) de la matrice de représentation d'images (1), celle-ci reposant directement ou indirectement contre le boîtier, et une seconde branche (85) reposant directement ou indirectement contre la vitre frontale (10) et exerçant une pression de serrage sur la vitre frontale (10) en direction de la matrice de représentation d'images (1).

4. Agencement de reproduction d'images selon l'une quelconque des revendications précédentes, qui présente des éléments d'écartement (36 ; 81), par lesquels la vitre frontale (10) est positionnable à distance de la matrice de représentation d'images (1).

5. Agencement de reproduction d'images selon l'une quelconque des revendications précédentes, pour lequel les éléments de fixation (6, 7, 8, 9 ; 83) présentent des moyens d'ajustement (50), avec lesquels la vitre frontale (1) est coulissante et/ou rotative parallèlement au plan de matrice de reproduction d'images (1).

6. Agencement de reproduction d'images selon l'une quelconque des revendications précédentes, présentant des barres profilées (15, 16, 17, 18 ; 80) qui sont agencées le long des bords (2, 3, 4, 5) de la matrice de représentation d'images (1), chaque barre profilée (15, 16, 17, 18 ; 80) présentant une surface d'appui (19, 20, 21, 22) pour la vitre frontale (10) qui est agencée parallèlement au plan de la matrice de représentation d'images (1) et les éléments de fixation (6, 7, 8, 9 ; 83) étant montés sur les barres profilées (15, 16, 17, 18) ou étant formés comme élément intégral sur les barres profilées.

7. Agencement de reproduction d'images selon la revendication 6, pour lequel les barres profilées présentent des éléments de fixation (6, 7, 8, 9 ; 83) avec des éléments de serrage (11, 12, 13, 14), les éléments de serrage exerçant une pression de serrage sur la vitre frontale en direction de la matrice de représentation d'images (1).

8. Agencement de reproduction d'images selon la revendication 6, pour lequel les barres profilées (80) présentent des éléments de fixation (83) qui sont configurés en forme de L, une branche (84) de l'élément de fixation en forme de L étant montée latéralement sur la barre profilée (80) et une seconde branche (85) reposant contre la vitre frontale (10) et exerçant une pression de serrage sur la vitre frontale (10) en direction de la matrice de représentation d'images (1).

9. Agencement de reproduction d'images selon l'une quelconque des revendications 6 à 8, pour lequel des barres profilées en regard l'une de l'autre identiques sont agencées respectivement sur des bords en regard (2/4, 3/5) de la matrice de représentation d'images (1).

10. Agencement (70) de plusieurs agencements de reproduction d'images selon l'une quelconque des revendications 1 à 9, plusieurs agencements de reproduction d'images étant agencés l'un à côté de l'autre et/ou l'un au-dessus de l'autre de sorte que les matrices de représentation d'images individuelles des agencements de reproduction d'images soient réunies en une matrice de représentation d'images agrandie.
